# EUROPEAN PATENT APPLICATION

(11) **EP 0 887 434 A1**
(43) Date of publication of application: **30.12.1998**
(21) Application number: 98304860.4
(22) Date of filing: 19.06.1998
(51) Int. Cl.: C23C 14/30, C23C 14/24, C23C 14/54

(54) **Apparatus for level control of a molten metal pool**

(30) Priority: 23.06.1997 US 880248
(71) Applicant: THE BOC GROUP, INC., Murray Hill, New Providence, New Jersey 07974-2082 (US)
(72) Inventor: Smith, P.A. Joel, San Pable, California 94806 (US); Chang, Ping, Danville, California 94506 (US)
(74) Representative: Bousfield, Roger James

(57) **Abstract**

An electron-beam evaporation system comprising: a rod fed source including an ingot rod (52), a rod feeder (72), and a crucible (58) through which the ingot rod is fed, the rod-fed source having at least a first and second operating position wherein the tip of the ingot rod is higher in the second position than in the first position; an electron-beam evaporation source (50) for evaporating the ingot rod; and a detector (60) adapted to produce a signal indicative of the evaporant deposition rate at the detector position, the detector positioned such that for the first operating position of the ingot rod in the electron-beam evaporation system, there is a first evaporant deposition rate and for the second operating position of the ingot rod in the electron-beam evaporation system, there is a second evaporant deposition rate at the detector position, wherein the detector is positioned such that the first evaporant deposition rate is less than the second evaporant deposition rate and wherein the electron-beam evaporation system is able to evaporate the material of the ingot rod in both the first and second operating positions.

## Description

This invention relates to electron-beam evaporation systems and more particularly, to pool height monitors for such systems.

Electron-beam evaporation systems direct an electron-beam to a material such that the material evaporates and can coat a substrate. The material used in the electron-beam evaporation system is typically fed as a rod through a crucible to a position in which the rod is impinged by the electron-beam. Coating efficiency, composition and uniformity can be very susceptible to pool height changes.

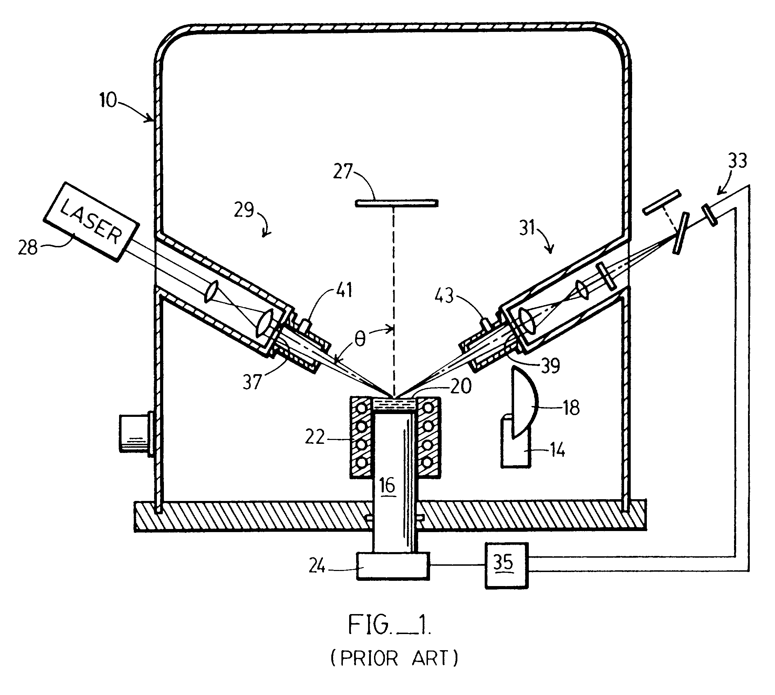

Figure 1 shows a prior art electron-beam evaporation system using a pool height monitor using a laser. Figure 1 is adapted from that disclosed in US Patent No. 3,574,650 entitled in which a vacuum chamber 10 includes an ingot material 16 positioned within a water-cooled copper crucible 22. An electron gun 14 produces an electron-beam which is deflected by magnets 18. The electron-beam impinges upon the ingot 16 and, in this case, forms a pool of molten material having a surface 20. A laser 28 is focused by the focusing optic 29 to reflect off the surface 20 back to detector optics 31. A detector 33 sends signals to a signal processor 35 which controls an actuator 24. In this way, the system can determine the position of the surface 20 and the rod material 16 can be fed up to maintain the surface 20 at a desired position as the rod material evaporates.

A disadvantage of such an optical detector system is that two port windows 37 and 39 must be used. The port windows can become coated as a result of the evaporation of the ingot material. In order to avoid the coating problem, the system described in the US patent uses inert gas to sweep through ports 41 and 43. As the required vacuum in electron-beam evaporation systems increases, the amount of gas needed to protect the ports 37 and 39 from coating by the evaporated material becomes unacceptable.

The invention is concerned with the provision of an improved pool height monitor for use with an electron-beam evaporation system.

In accordance with the invention, there is provided an electron-beam evaporation system comprising a rod fed source including an ingot rod, a rod feeder, and a crucible through which the ingot rod is fed, the rod-fed source having at least a first and second operating position wherein the tip of the ingot rod is higher in the second position than in the first position; an electron-beam evaporation source for evaporating the ingot rod; and a detector adapted to produce a signal indicative of the evaporant deposition rate at the detector position, the detector positioned such that for the first operating position of the ingot rod in the electron-beam evaporation system, there is a first evaporant deposition rate and for the second operating position of the ingot rod in the electron-beam evaporation system, there is a second evaporant deposition rate at the detector position, wherein the detector is positioned such that the first evaporant deposition rate is less than the second evaporant deposition rate and wherein the electron-beam evaporation system is able to evaporate the material of the ingot rod in both the first and second operating positions.

In general, the invention uses a detector adapted to produce a signal indicative of the evaporant deposition rate at the detector position. No port window is required for the detector, and thus no sweeping gas is required. The detected evaporant material is used to produce the information that indicates the position of the ingot rod.

For example, the detector can be positioned so that as the top position of the ingot rod moves up the detected evaporation deposition rate sharply rises. This allows the detected evaporant deposition rate to be used to control the position of the ingot rod.

When the detector is positioned within an angle of 30 of the ingot rod this effect is particularly noticeable. In a preferred embodiment, the detector is positioned substantially near the plane of the top crucible surface.

Evaporant deposition rate detectors are typically positioned near the substrate so as to give an accurate indication of the deposition rate at the substrate. When the detector is at this position, the deposition rate does not sharply or consistently depend on the pool height, so that a position of the ingot rod cannot be accurately determined from the deposition rate information.

In a preferred embodiment, the detector is positioned within a vacuum chamber so that for a first operating position of the ingot rod in the electron-beam evaporation system, a region of high local density of evaporant particles is not in the line of sight of the detector but for a second higher operating position of the ingot rod, a region of high local density of evaporant particles is in the line of sight of the detector. As described in the electron-beam technology section of the book *"Physical Vapor Deposition"* by R. Hill, 1986, Second Edition, pages 17-106, which is incorporated herein by reference, in the evaporant deposition of materials from an ingot rod at certain pressures and powers, there is a region of high local density of evaporant particles, or "virtual source" slightly above the ingot rod. This "virtual source" appears to be the origin of the evaporant material rather than the top surface of the ingot rod.

The "virtual source" is in the line of sight of the detector for some operating positions of the system, but is not in a line of sight for other operating positions of the system. In this way, the detector can be used to determine whether the ingot material is at a threshold position. The detector will be able to detect a signal for some of the ingot operating positions, but will get little or no signal for other operating positions, because in these other operating positions the "virtual source" is out of the line of sight of the detector. In a preferred embodiment, positions of the "virtual source" above the top of the crucible can be detected by the detector, while positions of the "virtual source" below the top of the crucible cannot be detected by the detector.

As the ingot rod moves up, more and more of the virtual source is not obscured by the crucible and the detected signal rises. In one preferred embodiment, the detector comprises a crystal oscillator. With a crystal oscillator, the coating of the device is not a problem because the crystal oscillator works by detecting the change in a surface acoustic wave as a result of the deposited thickness. As deposition material is added to the crystal, the crystal frequency changes. The change of frequency can be used to determine the deposition rate. The detector crystal is preferably used with a collimator. The collimator tube is typically cylindrical with holes in both ends so as to restrict the origin of detected evaporated material to a position in the line of sight of the detector. This position is preferably right above the top of the crucible.

Additionally, a shutter mechanism is used so that, after the position of the ingot rod is set, during the normal operation of the electron-beam evaporation system, no material impinges upon the detector crystal. In this way, the operating life of the detector crystal can be lengthened.

As discussed above, in the past crystal monitors have been positioned near the substrate so as to get an indication of the deposition upon the substrate. These prior art systems would be inappropriate for positioning the ingot rod, because a substantial amount of deposition will occur during all the operating positions of the ingot rod. It is impractical to use data from such a prior art detector to get an accurate indication of the position of the ingot rod.

The detector is preferably positioned so that some operating positions receive a very small signal and some operating positions have a relatively large detector signal. This produces an easy-to-use "bright-line" indication of whether the ingot material is at or above a threshold position.

In an alternative embodiment, a detector can be an electron ionisation emission spectrometer rate monitor. These devices have an input hole that can receive the evaporated material. This material is then ionised and then examined, so that an evaporation rate can be analysed. This type of device can be used during the normal processing of the electron-beam evaporation system. For this reason, the EIES rate monitor would be useful for closed-loop operation of the electron-beam evaporation system.

Other detectors would be less advantageous. An optical monitor, heat sensor, or imaging device would require the detector actually to see the device and would require a porthole which could become coated with the evaporated material.

The invention can be used with ingot rods which form a molten liquid when the electron-beam impinges upon the ingot rod. Alternately, the ingot rod can be a material that sublimes when impinged by the electron-beam at low pressure. The subliming material does not produce a molten pool.

Reference will now be made, by way of exemplification only, to the accompanying drawings in which:

Figure 1 is a diagram of a prior art electron-beam evaporation system using a laser-based pool-height monitor as discussed above.

Figure 2 is a diagram of an electron-beam evaporation system with a pool-height monitor of one embodiment of the invention.

Figure 3 is a diagram illustrating a detector of one embodiment of the invention shown with an ingot rod which forms a molten pool.

Figure 4 is a diagram of a detector of one embodiment of the invention shown with an ingot rod that sublimes.

Figure 5 is a diagram illustrating some of the parts of the electron-beam evaporation system used with one embodiment of the pool-height detector of the invention.

Figure 6 is a graph of deposition rate versus pool height for the deposition of aluminium when the detector is positioned near the substrate.

Figure 7 is a graph of deposition rate versus pool height for the deposition of aluminium when the detector is positioned near the plane of the crucible top surface.

Figure 8 is a graph of deposition rate versus pool height for the deposition of molybdenum when the detector is positioned near the plane of the crucible top surface.

Figure 9 is a graph of the deposition rate versus pool height for the deposition of chromium when the detector is positioned near the plane of the crucible top surface.

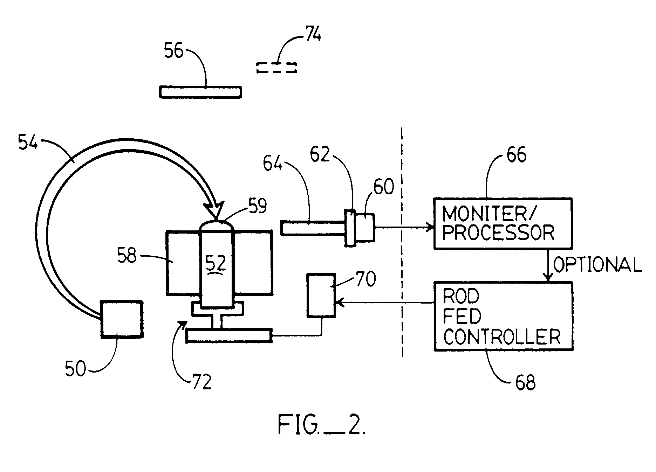

With reference to the drawings, Figure 2 is a diagram of an electron-beam evaporation system with a pool-height monitor of the invention. An electron-beam source 50 is positioned in magnetic deflectors (not shown) to deflect 270 and impinge on a ingot rod 52. The electron-beam 54 heats the ingot rod material 52 so that it evaporates and forms a deposition on the substrate 56. A water-cooled crucible 58 holds the ingot rod 52. A liquid reserve 59 of the ingot rod 52 is formed in this embodiment. A detector 60 is placed near the plane about the top surface of the crucible 58. In a preferred embodiment, the crystal detector used is an "Inficon" 6MHz gold crystal oscillator.

A shutter 62 can be closed during the normal operation of the electron-beam evaporation system. The shutter can be opened to help position the rod material before normal operation. A collimator 64 is a metal tube that helps ensure that the evaporated material detected by the crystal oscillator 60 comes from a position in the line-of-sight defined by the collimator. The collimator will filter out stray evaporant material coming from other directions.

The detector sends a signal to a monitor processor outside of the chamber. A monitor/processor 66 can produce an indication of the detector signal. A rod-fed controller 68 sends a signal to a motor 70 to move a rod feeder 72 upward.

In a preferred embodiment, the operation of the detector is as follows. Before the deposition operation occurs, or preferably after a previous deposition process finishes, the shutter 62 is opened for a given time period. If the signal from the detector 60 is below a certain threshold, the user can cause the rod controller to step up the rod 52 a given distance, at which point the test is repeated. If the detected signal is above a certain threshold, the rod is considered to be in the correct position.

In a preferred embodiment, the shutter is opened for ten seconds for each test, and the signal threshold is about ten Å/sec for a chromium deposition. The threshold value depends on the evaporant materials and electron-beam powers. The ingot rod 52 is stepped up in increments of 0.1 inch. The motor 70 can in a preferred embodiment be a "Globe Motor" Part No. M319M118 available from Globe Motor of Dayton, Ohio.

In prior systems, detectors have been placed in places near the substrate 56, such as a position 74, shown in phantom. These detectors have been used to determine the thickness of the layer deposed on the substrate 56.

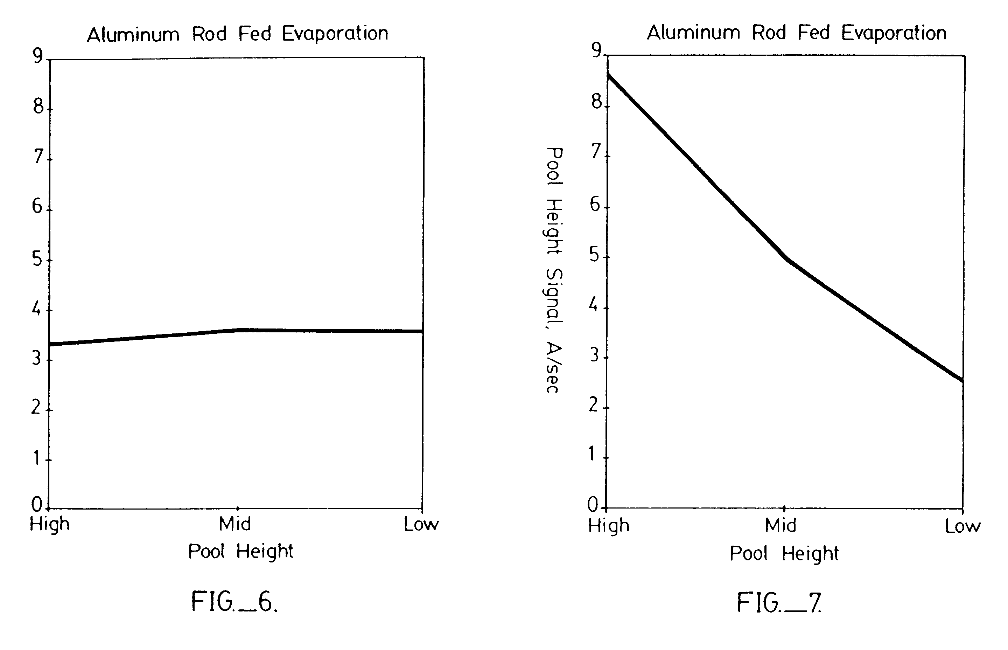

A detector at the position 74 would be inappropriate for use as a pool-height monitor, because deposition occurs for all the operating positions of the ingot rod. It is difficult, if not impossible, to determine the position of the ingot rod using data from a detector at the position 74. Figure 6 is an illustration of the deposition rate of an aluminium rod fed evaporation versus pool height when the detector is positioned near the substrate. Because of the relative flatness of this curve the deposition rate cannot be used to indicate the pool height.

Figure 7 is an illustration of the deposition rate of an aluminium rod fed evaporation versus pool height when the detector is positioned near the plane defined by the crucible top surface. Note that the deposition rates of the system provide significant information about the pool height. Even if the detector was off by one or two angstroms per second, it would be possible roughly to determine the pool height. Note that the deposition rate when the pool is high is about 2½ times the deposition rate when the pool is low.

Additionally, an optional connection between the monitor/processor 66 and the rod-fed controller 68 can allow for closed loop operation of the system in which the signal from the detector can cause the rod fit controller to position the ingot rod 52. This type of system is best when used with a detector that is an electron ionisation emission spectrometer rate monitor. One such device is a "Sentinel" available from Leybold Inficon, Inc. of East Syracuse, New York.

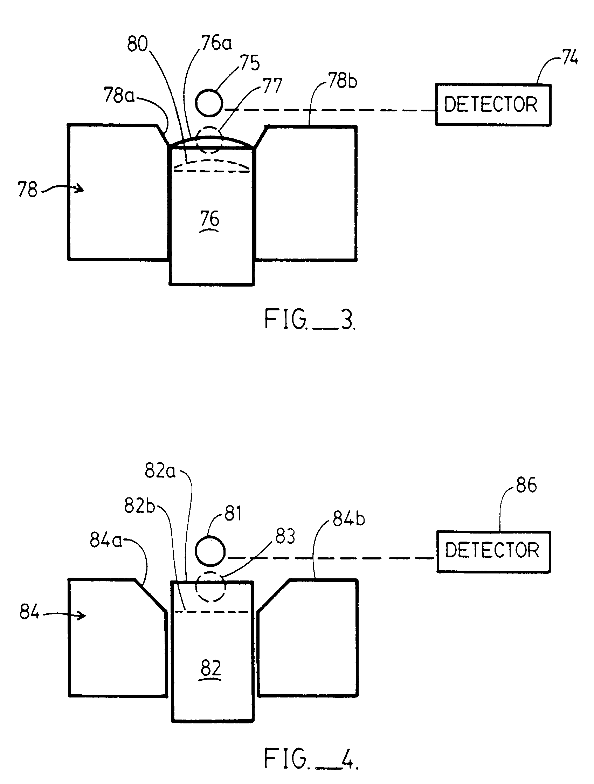

Figure 3 is a diagram of a electron-beam evaporation system using one embodiment of a detector of the invention. In this embodiment, the ingot rod material forms a liquid pool 76a. The detector 74 is positioned at or slightly above a plane defined by the top surface of the crucible 78. An area of high local density of evaporant particles 75 is positioned in the line-of-sight of the detector 74, above the crucible 78. The dotted area 80 shows the position of the pool at a lower position of the ingot rod 76. At this lower position, the area of high local density of evaporant particles 77 is not in the line-of-sight of the detector 74. The detected signal is significantly greater when the rod 76 is at point 76a rather than point 80. A detector positioned directly above the ingot rod 76 would not be able clearly to distinguish between the rod positions 76a and 80.

In a preferred embodiment, when the ingot rod 76 forms a liquid reserve, the crucible contacts the ingot rod 76 and the crucible includes a slightly tilted portion 78a formed at an angle of ten degrees from the vertical for a distance of about 0.25 inches.

The detector 74 is preferably in the horizontal plane at or slightly above the surface 78b of the crucible 78. It is also possible for the detector 74 to be positioned to point a slight angle down towards the molten pool. The systems that provide the detector a slight angle have the disadvantage that they would not show as sharp a rise in the detected signal as the ingot rod moves upward.

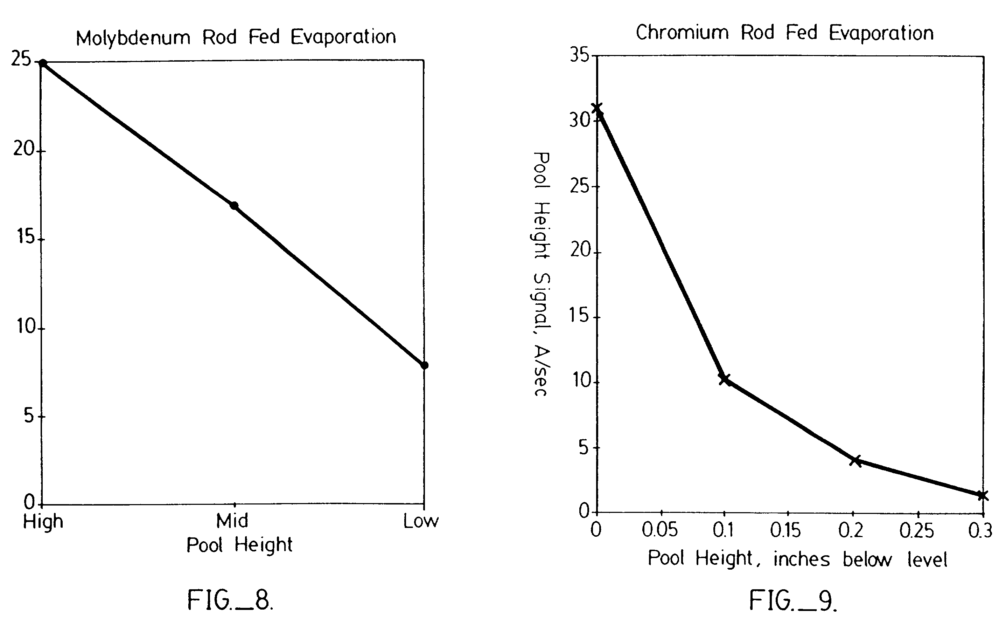

Figure 8 shows a graph of the detected evaporation rate versus pool height for molybdenum. Molybdenum forms a molten pool. The detector is positioned near the plane of the crucible top. Note that the deposition rate gives good information as to the pool height position.

Figure 4 shows a solid subliming material 82. This solid subliming material can be chromium. Subliming materials do not produce a liquid pool, but the term "pool-height monitor" will still be used to indicate the rod position. In this embodiment, the ingot rod 82 is shown as being free-standing. The use of a free-standing rotational rod is described in our co-pending European Application of even date and same title (inventors Russell J. Hill, P.A. Joel Smith and Ping Chang), the contents of which are incorporated herein by reference. As described in our co-pending Application, the rods at the source 82 can be pushed up through a crucible 84 without contacting the crucible. The crucible 84 has a tilted surface 84a angled at a larger angle than the tilted surface area of the crucible 78 shown in Figure 3.

Looking again at Figure 4, a detector 86 can detect evaporated material from the ingot rod at a position 82a but is unable to detect as much evaporated material from the ingot rod 82 if the ingot rod is in a position 82b, shown in phantom. In a preferred embodiment, the detector is positioned in a plane substantially parallel with the crucible surface 84b and slightly above the plane of this surface. Once the area of high local density of evaporant particles 81 moves above the crucible surface 84b, the crucible 84 no longer blocks the evaporant material. When the rod surface is at position 82b, the area of high local density of evaporant particles 83 has positioned out of the line-of-sight of the system. The area of high local density of evaporant particles need not be completely obscured or uncovered for the detected signal to give some indication of the position of the rod.

Figure 9 is a graph of the detected evaporant rate versus pool height for chromium. Chromium is a material that sublimes during the evaporant process. The detector is positioned near the plane of the crucible top surface. Note the strong dependence of deposition rate on pool height position.

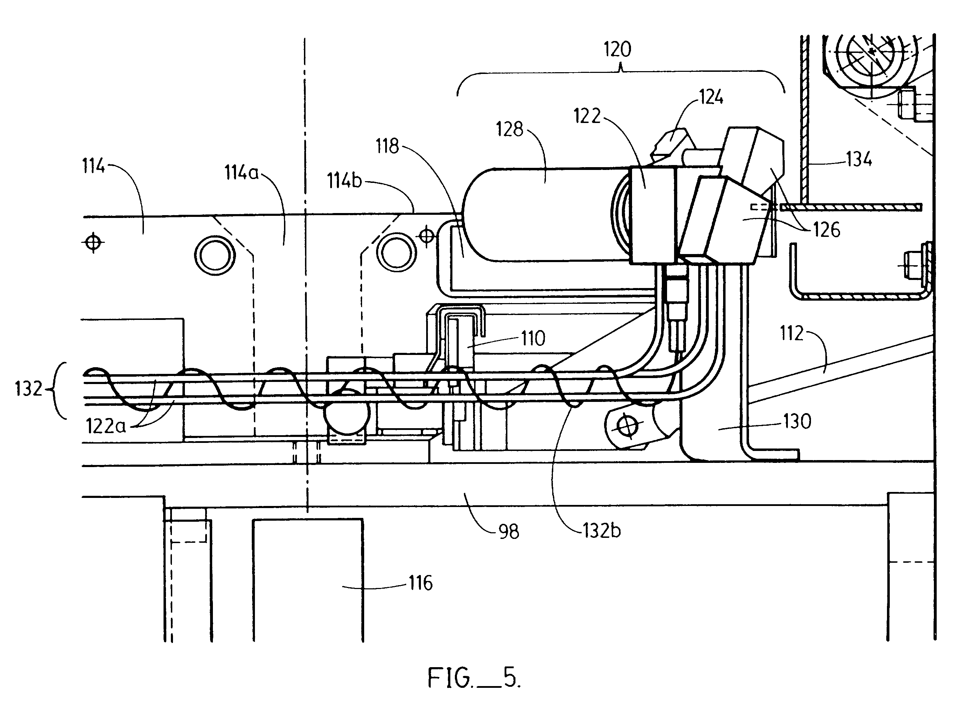

Figure 5 is a diagram illustrating some of the parts of an electron-beam evaporation system. The detector system 120 includes a collimator 128. In a preferred embodiment, the collimator 128 is a cylindrical tube 2.5 inches long and one inch in diameter. The collimator 128 has a front hole and rear holes. Only the evaporated material passing through both holes can be detected. In one embodiment, the front hole is 0.46 inches in diameter, and the back hole is approximately 0.406 inches in diameter. The centre of the collimator holes are centred at or slightly above the top of the crucible surface 114d.

A shutter 124 is connected to a shutter activator 126 which allows the crystal detector 122 to be protected from the evaporated material during the normal operation of the electron-beam evaporation system. The detector 122 preferably uses a crystal detector, such as a "Temescal" 6MHz gold crystal detector. The detector 122 is water-cooled through coolant pipes 132b of the supply lines 132. Microdot cable 132b is used to send the detector signal out of the chamber to the monitor/processor (not shown). The whole shown system is set on a base 98. The ingot rod 116 is fed upward by the rod feeder (not shown). A preferred embodiment of the invention uses a rotating mechanism (not shown). The ingot rod 116 passes through a hole 114a of the crucible 114. The emitter source 110 sends the electron-beam to the ingot rod positioned in the throughole 114a. Coils 118 are used to direct the position of the electron-beam along the top of the ingot rod. Permanent magnets (not shown) are used to provide the 270 degree deflection. Lead 112 is connected to supply the power to the emitter of the electron-beam source 110. In a preferred embodiment, the electron-beam source 110 is a "Temescal" SFIH-270-2 available from BOC Coating Technology of Fairfield, California. The detector mechanism 120 is positioned on the bracket 130. Also shown is shielding 134.

## Claims

1. An electron-beam evaporation system comprising:
a rod fed source including an ingot rod (52, 76, 82), a rod feeder (72), and a crucible (58, 78, 84) through which the ingot rod (52, 76, 82) is fed, the rod-fed source having at least a first and second operating position wherein the tip of the ingot rod is higher in the second position (76a, 82a) than in the first position (80, 82b);
an electron-beam evaporation source (50) for evaporating the ingot rod (52, 76, 82); and
a detector (60, 74, 86) adapted to produce a signal indicative of the evaporant deposition rate at the detector position, the detector (60, 74, 86) positioned such that for the first operating position (80, 82b) of the ingot rod (52, 76, 82) in the electron-beam evaporation system, there is a first evaporant deposition rate and for the second operating position (76a, 82a) of the ingot rod (52, 76, 82) in the electron-beam evaporation system, there is a second evaporant deposition rate at the detector position, wherein the detector is positioned such that the first evaporant deposition rate is less than the second evaporant deposition rate and wherein the electron-beam evaporation system is able to evaporate the material of the ingot rod (52, 76, 82) in both the first and second operating positions.

2. An electron-beam evaporation system according to Claim 1 in which the detector (60,74,86) is positioned such that the second evaporant deposition rate is at least one Å/sec greater than first evaporant deposition rate.

3. An electron-beam evaporation system according to Claim 1 or Claim 2 in which the detector (60,74,86) is positioned such that the second evaporant deposition rate is at least 1.2 times greater than first evaporant deposition rate.

4. An electron-beam evaporation system according to any preceding claim further comprising a controller (68) adapted to use the detector signal to control the position of the ingot rod (52,76,82).

5. An electron-beam evaporation system according to Claim 4 in which the controller (68) is adapted to move the ingot rod (52,76,82) upward when the detected evaporant deposition rate at the detector (60,74,86) is below a predetermined level.

6. An electron-beam evaporation system according to any preceding claim in which the detector (60,74,86) is positioned near a horizontal plane aligned with a top surface of the crucible (58,78,84).

7. An electron-beam evaporation system according to any preceding claim in which the detector (60,74,86) is positioned such that in the first operating position (80,82b) of the ingot rod in the electron-beam evaporation system, the region of high local density of evaporant particles (77,83) is not in the line of sight of the detector but for the second operating position (76a, 82a) of the ingot rod in the electron-beam evaporation system, the region of high local density of evaporant particles (75,81) is in the line of sight of the detector.

8. An electron-beam evaporation system according to any preceding claim in which the detector (60,74,86) includes an electron ionisation emission spectrometer rate monitor.

9. An electron-beam evaporation system according to any preceding claim in which the ingot rod (52,76,82) comprises a material that liquefies when heated by an electron-beam in a low-pressure environment.

10. An electron-beam evaporation system according to any one of Claims 1 to 8 in which the ingot rod (52,76,82) comprises a material that sublimes when heated by an electron-beam in a low-pressure environment.
